# EUROPEAN PATENT APPLICATION

(11) **EP 4 661 298 A1**
(43) Date of publication of application: **10.12.2025**
(21) Application number: 25315191.4
(22) Date of filing: 28.05.2025
(51) Int. Cl.: H03M 1/48, G01D 5/20, H02P 6/16

(54) **REAL-TIME SYNCHRONIZATION TECHNIQUE FOR RECTIFICATION OF RESOLVER FEEDBACKS**

(30) Priority: 05.06.2024 US 202418734535
(71) Applicant: STMicroelectronics International N.V., 1228 Plan-les-Ouates, Geneva (CH)
(72) Inventor: Angrilli, Riccardo, 26013 Crema (Cremona) (IT); Colombo, Filippo, 20900 Monza (Monza Brianza) (IT); Aubenas, Charles, 75013 Paris (FR); Casiraghi, Mattia, 20844 Triuggio (Monza Brianza) (IT)
(74) Representative: Buzzi, Notaro & Antonielli d'Oulx S.p.A.

(57) **Abstract**

Methods, systems, and apparatuses for real-time synchronization techniques for rectification of resolver feedbacks are provided. Various embodiments of the present disclosure include generating a synchronized rectification sign signal in real-time, aligned to an external delay, using a sign of modulated feedback waves. Various embodiments may include a process for reconstructing the sign by dynamically selecting the larger signal (in absolute value) of at least one sine signal and at least one cosine signal.

## Description

### TECHNOLOGICAL FIELD

Example embodiments of the present disclosure relate generally to real-time synchronization techniques for rectification of resolver feedbacks.

### BACKGROUND

Various applications use traction inverter systems of electric motors, such as automotive applications. These traction inverter systems include motor position sensors. A resolver is a type of motor position sensor used to measure the rotational position of a shaft of a motor. Resolvers receive an excitation signal and generate two analog signals as feedback about electric motor position (e.g., angle) as a consequence of the excitation signal. The two analog signals are a sine amplitude modulated signal and a cosine amplitude modulated signal.

The inventors have identified numerous areas of improvement in the existing technologies and processes, which are the subjects of embodiments described herein. Through applied effort, ingenuity, and innovation, many of these deficiencies, challenges, and problems have been solved by developing solutions that are included in embodiments of the present disclosure, some examples of which are described in detail herein.

### BRIEF SUMMARY

Various embodiments described herein relate to real-time synchronization techniques for rectification of resolver feedbacks.

In accordance with some embodiments of the present disclosure, an example system is provided. In some embodiments, the system comprises a motor configured to have one or more positions; a micro controller unit (MCU) configured to generate a rectification signal; a resolver configured to generate at least one sine signal and at least one cosine signal based on the rectification signal generated by the MCU and based on an initial position of the one or more positions of the motor; and a signal rectifier in the MCU, wherein the signal rectifier is configured to reconstruct a sign signal based on a position sensing variable, wherein the position sensing variable is based on an absolute value of at least one sine sample signal exceeding a threshold or an absolute value of at least one cosine sample signal exceeding the threshold.

In some embodiments, the MCU is further configured to provide, via a signal generator, the rectification signal to the resolver.

In some embodiments, the MCU comprises a resolver interface circuitry, the resolver interface circuitry further comprising an excitation generator circuitry configured to generate an excitation signal and a demodulation circuitry configured to perform rectification sign signal reconstruction.

In some embodiments, the resolver interface circuitry is configured to generate the rectification signal, wherein the rectification signal is a rectification sign signal synchronized with one or more modulated feedbacks of the resolver.

In some embodiments, the resolver interface circuitry is configured to set a sign of the reconstructed sign signal based on a sign sample of the position sensing variable. In some embodiments, the threshold is associated with noise in the system.

In some embodiments, the position sensing variable is based on the initial position of the one or more positions of the motor.

In accordance with some embodiments of the present disclosure, an example apparatus is provided. In some embodiments, the apparatus comprises a micro controller unit (MCU) configured to generate a rectification signal; a resolver configured to receive one or more positions of a motor and configured to generate at least one sine signal and at least one cosine signal based on the rectification signal generated by the MCU and based on an initial position of the one or more positions of a motor; and a signal rectifier in the MCU, wherein the signal rectifier is configured to reconstruct a sign signal based on a position sensing variable, wherein the position sensing variable is based on an absolute value of at least one sine sample signal exceeding a threshold or an absolute value of at least one cosine sample signal exceeding the threshold.

In some embodiments, the MCU is further configured to provide, via a signal generator, the rectification signal to the resolver.

In some embodiments, the MCU comprises a resolver interface circuitry, the resolver interface circuitry further comprising an excitation generator circuitry configured to generate an excitation signal and a demodulation circuitry configured to perform rectification sign signal reconstruction.

In some embodiments, the resolver interface circuitry is configured to generate the rectification signal, wherein the rectification signal is a rectification sign signal synchronized with one or more modulated feedbacks of the resolver.

In some embodiments, the resolver interface circuitry is configured to set a sign of the reconstructed sign signal based on a sign of the position sensing variable.

In some embodiments, the threshold is associated with noise in the apparatus.

In some embodiments, the position sensing variable is based on the initial position of the one or more positions of the motor.

In accordance with some embodiments of the present disclosure, an example method is provided. In some embodiments, the method comprises receiving, by a resolver and from a motor, one or more positions of a motor; generating, by a micro controller unit (MCU), a rectification signal; generating, by the resolver and based on the rectification signal generated by the MCU and based on an initial position of the one or more positions of the motor, at least one sine signal and at least one cosine signal; and reconstructing, by a signal rectifier in the MCU, a sign signal based on a position sensing variable, wherein the position sensing variable is based on an absolute value of at least one sine sample signal exceeding a threshold or an absolute value of at least one cosine sample signal exceeding the threshold.

In some embodiments, the MCU comprises a resolver interface circuitry, the resolver interface circuitry further comprising an excitation generator circuitry configured to generate an excitation signal and a demodulation circuitry configured to perform rectification sign signal reconstruction.

In some embodiments, the method further comprises generating, by the resolver interface circuitry, the rectification signal, wherein the rectification signal is a rectification sign signal synchronized with one or more modulated feedbacks of the resolver.

In some embodiments, the method further comprises setting, by the resolver interface circuitry, a sign of the reconstructed sign signal based on a sign of the position sensing variable.

In some embodiments, the threshold is associated with noise impacting the at least one sine sample signal or the at least one cosine sample signal.

In some embodiments, the position sensing variable is based on the initial position of the one or more positions of the motor.

The above summary is provided merely for purposes of summarizing some example embodiments to provide a basic understanding of some aspects of the disclosure. Accordingly, it will be appreciated that the above-described embodiments are merely examples and should not be construed to narrow the scope or spirit of the disclosure in any way. It will also be appreciated that the scope of the disclosure encompasses many potential embodiments in addition to those here summarized, some of which will be further described below.

### BRIEF SUMMARY OF THE DRAWINGS

Having thus described certain example embodiments of the present disclosure in general terms, reference will now be made to the accompanying drawings, which are not necessarily drawn to scale, and wherein:
FIGS. 1A-1B illustrate an exemplary method for a real-time synchronization technique for rectification of resolver feedbacks, in accordance with one or more embodiments of the present disclosure.
FIG. 2 illustrates an exemplary signal generator, in accordance with one or more embodiments of the present disclosure.
FIG. 3 illustrates an exemplary micro controller unit (MCU), in accordance with one or more embodiments of the present disclosure.
FIG. 4 illustrates a reconstruction of a sign signal, in accordance with one or more embodiments of the present disclosure.
FIG. 5 illustrates a comparison of reference signals, in accordance with one or more embodiments of the present disclosure.
FIG. 6 illustrates a reconstruction of an excitation sign signal based on resolver feedbacks, in accordance with one or more embodiments of the present disclosure.
FIG. 7 illustrates an exemplary device for implementing rectification of resolver feedbacks using a real-time synchronization technique, in accordance with one or more embodiments of the present disclosure.

### DETAILED DESCRIPTION

Some embodiments of the present disclosure will now be described more fully herein with reference to the accompanying drawings, in which some, but not all, embodiments of the disclosure are shown. Indeed, various embodiments of the disclosure may be embodied in many different forms and should not be construed as limited to the embodiments set forth herein; rather, these embodiments are provided so that this disclosure will satisfy applicable legal requirements. Like reference numerals refer to like elements throughout.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in various embodiments," "in one embodiment," "according to one embodiment," "in some embodiments," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments or it may be excluded.

### OVERVIEW

Various embodiments provide for methods, systems, and apparatuses for real-time synchronization techniques for rectification of resolver feedbacks. Various embodiments of the present disclosure include generating a synchronized rectification sign in real-time, aligned to an external delay, using a sign of modulated feedback waves. Various embodiments may include a process for reconstructing the sign by dynamically selecting the larger signal (in absolute value) of at least one sine signal and at least one cosine signal.

Various embodiments include methods for reconstruction of sign signals based on one or more position sensing variables. The one or more position sensing variables may be determined based on analysis of modulated sine and/or cosine sample signals. The sine and/or cosine sample signals may be obtained by analog to digital conversion (e.g., by analog-to-digital converters (ADCs) comprised by a micro controller unit (MCU) and/or elsewhere in a system). The modulated sine and/or cosine sample signals may be compared to one or more thresholds to eliminate noisy signals. The modulated sine and/or cosine sample signals may be compared to one another to determine the larger, in absolute value, of the signals. Based on determining the larger of the signals and based on further determining whether the sine and/or cosine sample signals are positive, the one or more position sensing variables may be set. For example, the one or more position sensing variables may be set to values such as 0 and 1. After the position sensing variables are set, the sign signals may be reconstructed. The signs of the reconstructed sign signals may be set to be equal to the signs of the one or more position sensing variables or to be inversions of the signs of the one or more position sensing variables.

Feedback from a resolver may take the form of a sinusoidal signal, wherein the resolver feedback may be modulated by a sine and/or cosine envelope. Rectification of the resolver feedbacks may comprise rectification of one or more sample signals (e.g., at least one sine sample signal, at least one cosine sample signal, and/or the like) of amplitude modulated resolver outputs. Such a rectification of the resolver feedbacks may recover the sinusoidal and/or cosinusoidal envelope of the feedbacks. During such a rectification, a sign signal (e.g., a signal that rectifies incoming sample signals) may be relied upon. To obtain the sign signal with precision, an external delay resulting from excitation signals originating from the resolver may be accounted for. After rectification of the resolver feedbacks, an integration procedure may be implemented to achieve demodulation of the resolver feedbacks.

Various embodiments include apparatuses configured to reconstruct sign signals. For example, a signal generator may be configured to generate excitation signals. The excitation signals may be demodulated during reconstruction of the sign signals. The signal generator may further comprise an internal logic such as a finite state machine (FSM). The internal logic may implement the methods described herein, such as the methods for reconstruction of sign signals based on one or more position sensing variables.

Various embodiments include systems configured to reconstruct sign signals. For example, a micro controller unit (MCU) of a traction inverter system of an electric motor may be configured to reconstruct sign signals while taking into account one or more external delays which may arise from excitation signals. The MCU may comprise resolver interface circuitry, which in turn may comprise a signal generator and signal rectifiers and integrators. The signal generator may be configured to generate excitation signals and provide those excitation signals to an amplifier circuit. The amplifier circuit may be configured to amplify the excitation signals and provide them to a resolver. The resolver may receive information indicating an initial angle of a rotor (e.g., of the electric motor). The resolver may, based on the initial angle of the rotor and the amplified signals, transmit a modulated sine signal to a sine signal rectifier and integrator and transmit a modulated cosine signal to a cosine signal rectifier and integrator.

Various embodiments include reconstruction of sign signals. For example, the reconstruction of sign signals may comprise two modulated outputs by the resolver as based on an excitation signal generated by the resolver interface logic comprised by the MCU. The reconstruction of sign signals may comprise reconstruction, by an internal logic such as an FSM, of the sign of the feedbacks (e.g., one or more sine signals, one or more cosine signals) received from the resolver, accounting for an external delay resulting from the sensor coils, cables, conditioning circuits, and/or the like.

Various embodiments include comparing reference signals (e.g., sine reference signals, cosine reference signals, and/or the like) to one another, for example, to determine which of absolute values of the reference signals is larger. Determining the larger signal may be used to increase accuracy during setting of one or more position sensing variables and/or during reconstruction of sign signals.

Various embodiments include reconstruction of excitation sign signals based on resolver feedback signals (e.g., at least one sine signal, at least one cosine signal, and/or the like). For example, based on switching between which is larger in absolute value of sine and/or cosine reference signals, position sensing variables may be set. In comparing the resolver feedback signals, it may be determined that the signals are in phase with one another at some times and antiphase to one another at other times. Based on determining whether the resolver feedback signals are in phase or antiphase, and based on starting values (e.g., initial values, current values, etc.) of one or more position sensing variables, an upcoming transition (e.g., from sine > cosine to cosine > sine) may be predicted.

Various embodiments include exemplary devices for implementing rectification of resolver feedbacks using real-time synchronization techniques. Such devices may include a traction inverter system of an electric motor. The exemplary devices may comprise processors, memory, input/output circuitry, user interface circuitry, and/or the like. Processors of the exemplary devices may include MCUs such as the MCU configured to reconstruct sign signals while taking into account one or more external delays which may arise from excitation signals.

The present disclosure includes numerous improvements. For example, the present disclosure allows for avoiding uncertainty where at least one sine signal and/or at least one cosine signal have minimal amplitudes. Various embodiments achieve real-time synchronization with data to be rectified. Various embodiments adapt to variable delays affecting returning feedbacks. Various embodiments manage external delays greater than one excitation period.

### EXEMPLARY METHODS, SYSTEMS, AND APPARATUSES

Various embodiments of the present disclosure include systems and apparatuses for improvement of real-time synchronization techniques for rectification of resolver feedbacks, which are described herein and may be implemented in various embodiments.

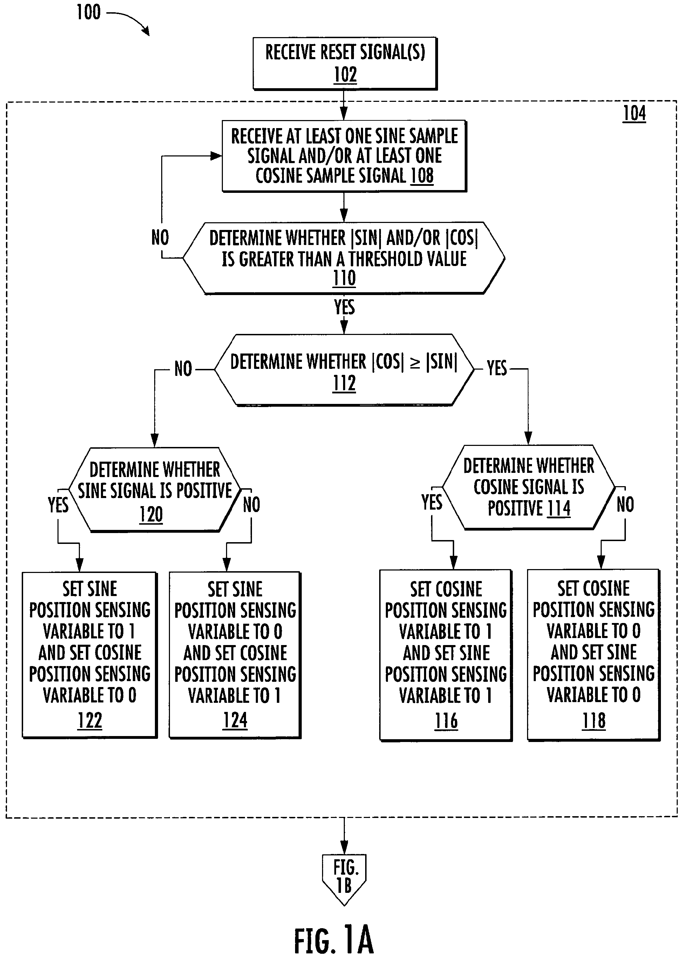

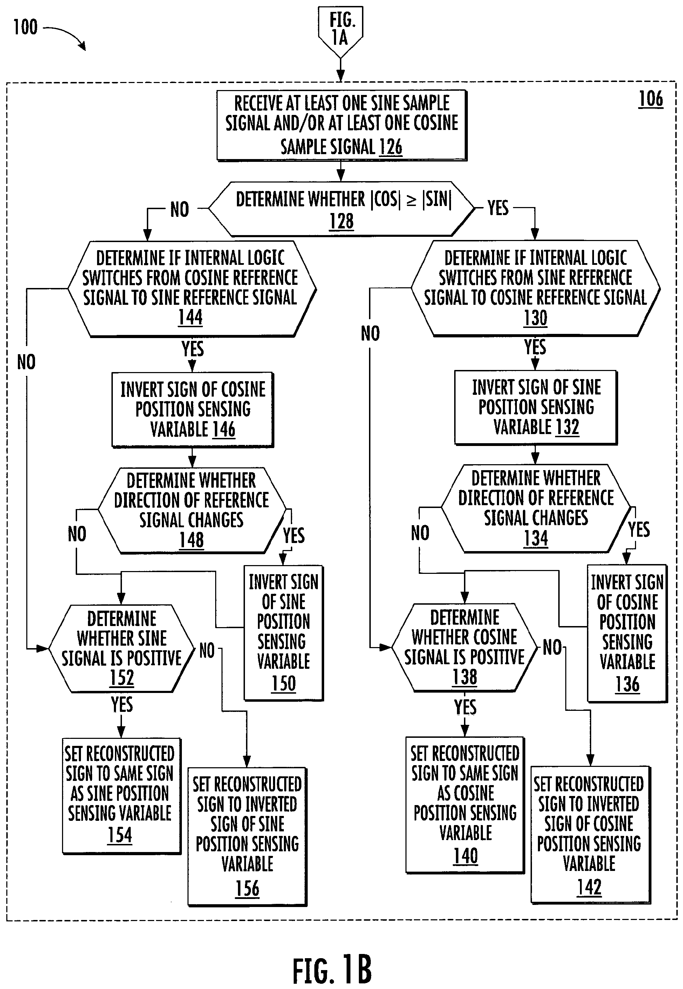

FIGS. 1A-1B illustrate a method 100 for a real-time synchronization technique for rectification of resolver feedbacks. FIG. 1A illustrates a reset stage 102 and a locking stage 104 of the method 100. FIG. 1B illustrates a locked stage 106 of the method 100. During the reset stage 102, one or more reset signals may be received. The one or more reset signals may be a global reset for a micro controller unit (MCU), or a dedicated reset of a resolver interface. For example, the one or more reset signals may be one or more sine signals and/or one or more cosine signals. During the locking stage 104, one or more position sensing variables may be set. For example, the one or more position sensing variables may be set based on analysis of at least one sine sample signal and/or at least one cosine sample signal. The at least one sine sample signal and/or the at least one cosine sample signal may be obtained by analog to digital conversion (e.g., by analog-to-digital converters (ADCs) comprised by an MCU and/or elsewhere in a system). The setting of the one or more position sensing variables may account for a starting angle (and/or position) of, for example, a resolver sensor (referred to herein as a "resolver"). During the locked stage 106, a sign signal (e.g., a synchronized rectification signal) may be reconstructed, for example, based on the one or more position sensing variables set during the locking stage 104. The locked stage 106 may be configured to reconstruct a sign signal of an excitation signal in real-time (e.g., contemporaneously with operation of the resolver). By implementing the method 100, a rectification sign signal may be reconstructed from modulated outputs of a resolver. A resolver may be an angular position sensor, for example, configured to measure an angular position of an electric motor and/or an electric motor shaft. The rectification sign signal may be reconstructed from modulated outputs of the resolver, for example, based on the one or more position sensing variables. An internal logic such as a finite state machine (FSM) may implement the method 100. If a position sensing variable of the one or more position sensing variables is determined to have a value of 1 (e.g., set to a value of 1), the reconstructed sign may be determined to have the same sign as the corresponding resolver output. For example, if the position sensing variable corresponding to the cosine resolver output is set to 1, then the reconstructed sign may have the same sign as the cosine resolver output (i.e., if the cosine resolver output is positive and the position sensing variable corresponding to the cosine resolver output is equal to 1, then the reconstructed sign may also be positive).

If a position sensing variable of the one or more position sensing variables is determined to have a value of 0 (e.g., set to a value of 0), the reconstructed sign may be determined to have the opposite and/or inverted sign of the corresponding resolver output. For example, if the position sensing variable corresponding to the cosine resolver output is set to 0, then the reconstructed sign may have the opposite and/or inverted sign of the cosine resolver output (i.e., if the cosine resolver output is positive and the position sensing variable corresponding to the cosine resolver output is equal to 0, then the reconstructed sign may be negative).

At operation 102, a reset signal may be received. For example, the reset signal may be a reset signal generated after power up by the MCU and/or a global reset of the resolver interface.

Operations 108 - 124 comprise the locking stage of the method 100.

A system (e.g., a micro controller unit (MCU) implementing the method 100) may wait for at least one new sine sample signal and/or at least one new cosine sample signal. For example, at operation 108, the system may receive at least one sine sample signal and/or at least one cosine sample signal. The at least one sine sample signal and/or the at least one cosine sample signal may be generated by a signal generator. The at least one sine sample signal and/or the at least one cosine sample signal may be provided to an amplifier circuit. The resolver may modulate the excitation signal. Demodulation may be performed by rectifying and integrating the received resolver output signals. The signal rectifiers and/or signal integrators may be configured to rectify the resolver feedbacks using a real-time synchronization technique.

At operation 110, a determination may be made as to whether an absolute value of the at least one sine sample signal and/or an absolute value of the at least one cosine sample signal is greater than a threshold value. The threshold value may be calibrated to allow the system to discard sine and/or cosine values impacted by noise. The system may be configured with the threshold during, for example, calibration of the system. The system may be configured with the threshold, for example, in view of a position of the rotor (or shaft, motor, etc.).

In the case of a "no" determination at operation 110, the system may implement operation 108 (e.g., continue to wait for at least one sine sample signal and/or at least one cosine sample signal not impacted by noise).

In the case of a "yes" determination at operation 110, at operation 112, a determination may be made as to whether an absolute value of the at least one cosine sample signal is greater than or equal to an absolute value of the at least one sine sample signal (e.g., whether |cos| >= |sin|). The determination of the larger signal allows for greater accuracy in reconstructing the rectification sign signal. In the case of a "yes" determination at operation 112, at operation 114, a determination may be made as to whether the at least one cosine sample signal is positive. For example, if the absolute value of the at least one cosine sample signal is greater than the absolute value of the at least one sine sample signal, the system may determine that cosine is the larger signal in absolute value. Based on cosine being the larger signal in absolute value, at operation 114, whether cosine is positive or negative may be determined.

In the case of a "yes" determination at operation 114, at operation 116, a cosine position sensing variable (e.g., COSINE_POSITIVE) may be set to a value of 1, and a sine position sensing variable (e.g., SINE_POSITIVE) may be set to a value of 1. For example, if the cosine signal is positive, then the position sensing variables may be set to the value of 1.

In the case of a "no" determination at operation 114, at operation 118, the cosine position sensing variable may be set to a value of 0, and the sine position sensing variable may be set to a value of 0. For example, if the cosine signal is negative, then the position sensing variables may be set to the value of 0.

In the case of a "no" determination at operation 112, at operation 120, a determination may be made as to whether the at least one sine sample signal is positive. For example, if the absolute value of the at least one sine sample signal greater than the absolute value of the at least one cosine sample signal, the system may determine that sine is the larger signal in absolute value. Based on sine being the larger signal in absolute value, at operation 120, whether sine is positive or negative may be determined.

In the case of a "yes" determination at operation 120, at operation 122, the sine position sensing variable may be set to a value of 1, and the cosine position sensing variable may be set to a value of 0. For example, if the sine signal is positive, the sine position sensing variable may be set to the value of 1, and the cosine position sensing variable may be set to the value of 0.

In the case of a "no" determination at operation 120, at operation 124, the sine position sensing variable may be set to a value of 0, and the cosine position sensing variable may be set to a value of 1. For example, if the sine signal is negative, the sine position sensing variable may be set to the value of 0, and the cosine position sensing variable may be set to the value of 1.

The value(s) of the position sensing variable(s) may be thus determined based on the starting (e.g., initial) angle of rotor (or shaft, motor, etc.).

The method 100 continues in FIG. 1B, which illustrates a locked stage of the method 100.

At operation 126, the system (e.g., the MCU implementing the method 100) may wait for at least one new sine sample signal and/or at least one new cosine sample signal. For example, at operation 126, the system may receive at least one sine sample signal and/or at least one cosine sample signal.

At operation 128, a determination may be made as to whether an absolute value of the at least one cosine sample signal is greater than or equal to an absolute value of the at least one sine sample signal (e.g., whether |cos| >= |sin|). The determination of the larger signal allows for greater accuracy in reconstructing the rectification sign signal.

In the case of a "yes" determination at operation 128, at operation 130, a determination may be made as to whether the internal logic (e.g., the FSM) switches from a sine reference signal to a cosine reference signal for the reconstruction (e.g., the switching may be performed dynamically throughout operation). The sine reference signal may be the sine modulated output of the resolver. The cosine reference signal may be the cosine modulated output of the resolver. Based on the FSM switching from the sine reference signal to the cosine reference signal, the position sensing variables may be changed. For example, if the cosine position sensing variable had a value of 1 and the FSM changed from the sine reference signal to the cosine reference signal, then the cosine position sensing variable may be changed to a value of 0. For example, if the sine position sensing variable had a value of 1 and the FSM changed from the sine reference signal to the cosine reference signal, then the sine position sensing variable may be changed to a value of 0. Similar changes may be implemented, for example, if the sine and/or cosine position sensing variables had values of 0.

In the case of a "yes" determination at operation 130, at operation 132, the logic value (e.g., sign) of the sine position sensing variable may be inverted. For example, if the sine position sensing variable was positive and the FSM switched from the sine reference signal to the cosine reference signal, then the sine position sensing variable may be inverted (e.g., since it was positive, it would become negative). As described herein, referring to a "positive" position sensing variable means that it has a value of 1, while referring to a "negative" position sensing variable means that it has a value of 0.

At operation 134, a determination may be made as to whether a direction of the reference signal changes. For example, a change in the direction of the reference signal may occur based on a change in a direction of the rotor (or shaft, motor, etc.). In the case of a "yes" determination at operation 134, at operation 136, the logic value of the cosine position sensing variable may be inverted. For example, if the direction of the reference signal changes, then the logic value of the cosine position sensing variable may be inverted (e.g., if it was positive, it would become negative; if it was negative, it would become positive, etc.).

In the case of a "no" determination at operation 134, at operation 138, a determination may be made as to whether the at least one cosine sample signal is positive. For example, if the direction of the reference signal is unchanged, then whether the cosine signal is positive may be determined.

In the case of a "no" determination at operation 130, at operation 138, a determination may be made as to whether the at least one cosine sample signal is positive. For example, if the FSM did not switch from the sine reference signal to the cosine reference signal, then whether the cosine signal is positive may be determined.

In the case of a "yes" determination at operation 138, at operation 140, a reconstructed sign may be set to the same logic value as the cosine position sensing variable. For example, if the cosine signal is positive, then the sign of the reconstructed rectification sign signal may be the same as the logic value of the cosine position sensing variable.

In the case of a "no" determination at operation 138, at operation 142, the reconstructed sign may be set to the inversion of the logic value of the cosine position sensing variable. For example, if the cosine signal is negative, then the sign of the reconstructed rectification sign signal may be the inverted logic value of the cosine position sensing variable.

In the case of a "no" determination at operation 128, at operation 144, a determination may be made as to whether the internal logic (e.g., the FSM) switches from a cosine reference signal to a sine reference signal. For example, if the absolute value of the at least one sine sample signal is greater than the absolute value of the at least one cosine sample signal, the system may determine whether the FSM switches from a cosine reference signal to a sine reference signal.

In the case of a "yes" determination at operation 144, the logic value of the cosine position sensing variable may be inverted. For example, if the cosine position sensing variable was positive and the FSM switched from the cosine reference signal to the sine reference signal, then the cosine position sensing variable may be inverted (e.g., since it was positive, it would become negative).

At operation 148, a determination may be made as to whether a direction of the reference signal changes. For example, a change in the direction of the reference signal may occur based on a change in a direction of the rotor (or shaft, motor, etc.). In the case of a "yes" determination at operation 148, at operation 150, the logic value of the sine position sensing variable may be inverted. For example, if the direction of the reference signal changes, then the logic value of the sine position sensing variable may be inverted (e.g., if it was positive, it would become negative; if it was negative, it would become positive, etc.).

In the case of a "no" determination at operation 148, at operation 152, a determination may be made as to whether the at least one sine sample signal is positive. For example, if the direction of the reference signal is unchanged, then whether the sine signal is positive may be determined.

In the case of a "no" determination at operation 144, at operation 152, a determination may be made as to whether the at least one sine sample signal is positive. For example, if the FSM did not switch from the cosine reference signal to the sine reference signal, then whether the sine signal is positive may be determined.

In the case of a "yes" determination at operation 152, at operation 154, a reconstructed sign may be set to the same logic value as the sine position sensing variable. For example, if the sine signal is positive, then the sign of the reconstructed rectification sign signal may be the same as the logic value of the sine position sensing variable.

In the case of a "no" determination at operation 152, at operation 156, the reconstructed sign may be set to the inversion of the logic value of the sine position sensing variable. For example, if the sine signal is negative, then the sign of the reconstructed rectification sign signal may be the inverted logic value of the sine position sensing variable.

Thus, the rectification sign signal may be reconstructed based on the modulated outputs of the resolver.

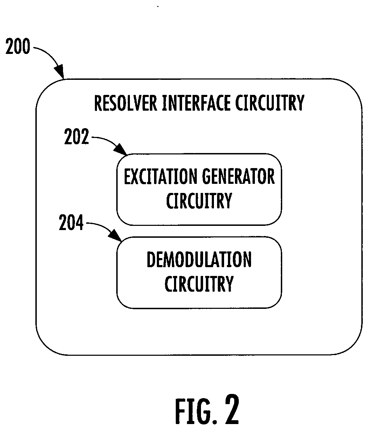

FIG. 2 illustrates an exemplary resolver interface circuitry 200. The resolver interface circuitry may comprise an excitation generator circuitry 202 and a demodulation circuitry 204. The excitation generator circuitry 202 may be configured to generate signals, for example, such as sine signals, cosine signals, and/or the like. The excitation generator circuitry 202 may comprise, for example, a signal generator. The demodulation circuitry 204 may be configured to demodulate signals, for example, such as sine signals, cosine signals, and/or the like. The excitation generator circuitry 202 may be configured to generate excitation signals. An example excitation signal may be comprised of a sine wave and a corresponding square wave, wherein the sine wave and the square wave have the same (or substantially the same) period. The excitation signals generated by the excitation generator circuitry 202 may be used to excite a resolver. The resolver may generate analog signals as feedback indicating a position (e.g., an angle) of a rotor (or shaft, motor, and/or the like) as a consequence of the excitation signal generated by the excitation generator circuitry 202. The demodulation circuitry 204 may be configured to perform rectification sign signal reconstruction.

The resolver interface circuitry 200 may be comprised by an MCU. The resolver interface circuitry 200 may comprise an internal logic such as a finite state machine (FSM). An FSM may be configured to occupy a single state of a plurality of states at a time. The internal logic may be configured to generate an excitation signal, wherein the internal logic may be an FSM and/or other types of logic. The internal logic may be configured to reconstruct sign signals, for example, without external intervention by a central processing unit (CPU) and/or external logic. The internal logic (e.g., the excitation generator circuitry logic) may be separate with respect to the logic to demodulate resolver feedbacks (e.g., the demodulation circuitry logic). The internal logic may be configured to implement methods such as the method 100 of FIGS. 1A-1B. For example, the internal logic may receive a sine reference signal and/or a cosine reference signal. The internal logic may switch between the sine reference signal and the cosine reference signal, which may indicate that one or more position sensing variables should be inverted (e.g., switched).

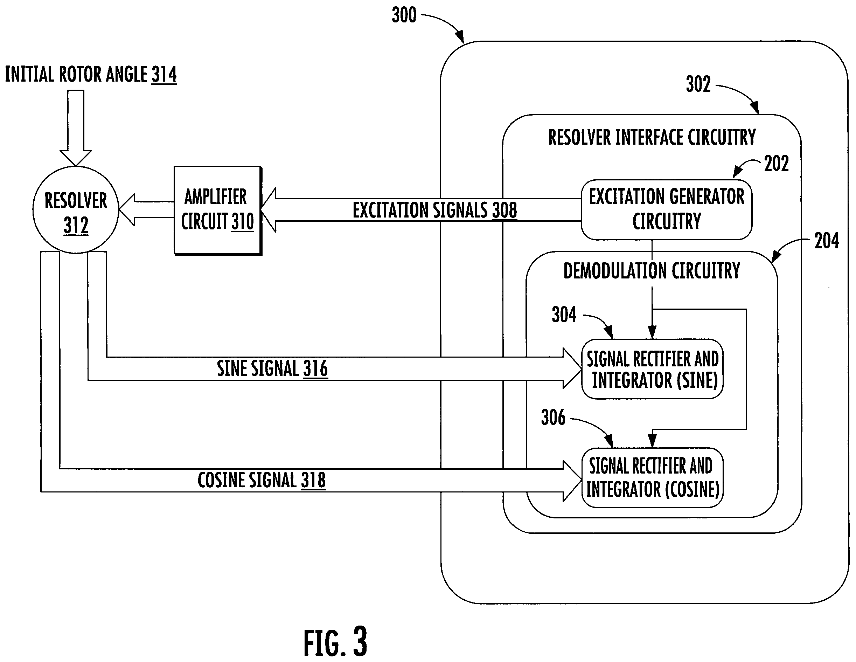

FIG. 3 illustrates an exemplary micro controller unit (MCU) 300. The MCU 300 may be an implementation of a system configured to reconstruct sign signals based on one or more position sensing variables. For example, the MCU 300 may be an MCU of a traction inverter system of an electric motor (e.g., such as in automotive applications). A traction inverter system may be used to convert direct current (DC), for example, of an electric vehicle's batteries, to an alternating current (AC).

The MCU 300 may comprise resolver interface circuitry 302. The resolver interface circuitry 302 may be configured to measure an angular position of an electric motor, an electric motor shaft, and/or an electric motor rotor. The resolver interface circuitry 302 may comprise the excitation generator circuitry 202, a demodulation circuitry 204, a sine signal rectifier and integrator 304, and a cosine signal rectifier and integrator 306. The excitation generator circuitry 202 may be configured to generate excitation signals 308 for exciting a resolver (further described below). The sine signal rectifier and integrator 304 and the cosine signal rectifier and integrator 306 may be configured to rectify and integrate sine and cosine signals, respectively, as will be described herein.

The excitation generator circuitry may generate at least one sine sample signal and/or at least one cosine sample signal (i.e., the excitation signals 308). The excitation signals 308 may be provided to an amplifier circuit 310. The amplifier circuit 310 may be configured to modulate (e.g., amplify) the incoming excitation signals 308. The amplifier circuit 310 may provide the modulated signals to a resolver 312. The resolver 312 may be excited by the excitation signals 308. The resolver 312 may modulate the excitation signal. Demodulation may be performed by rectifying and integrating the received resolver 312 output signals. The resolver 312 may be configured to receive an initial rotor angle 314 indicating an initial position of a rotor (or shaft, motor, etc.). Based on the initial rotor angle 314 and/or the modulated signals received from the amplifier circuit 310, the resolver 312 may provide demodulated signals (e.g., at least one demodulated sine sample signal 316 and/or at least one demodulated cosine sample signal 318) to the sine signal rectifier and integrator 304 and/or the cosine signal rectifier and integrator 306, respectively. The sine signal rectifier and integrator 304 and/or the cosine signal rectifier and integrator 306 may be configured to rectify resolver feedbacks (e.g., the sine signal 316 and/or the cosine signal 318) using a real-time synchronization technique such as the method 100 described herein with respect to FIGS. 1A-1B. The real-time synchronization technique accounts for external delays imparted to the resolver by the excitation signals 308. The real-time synchronization technique may be implemented contemporaneously with operation of the resolver 312, allowing for continuous updating of the one or more position sensing variables.

An advantage of the real-time synchronization technique is that the rectification sign signal is reconstructed in real-time based on the actual incoming samples of the resolver outputs. Delays are not estimated by a user, so the system is attuned to changing or oscillating delays. The system is thus able to remain synchronized with new incoming samples.

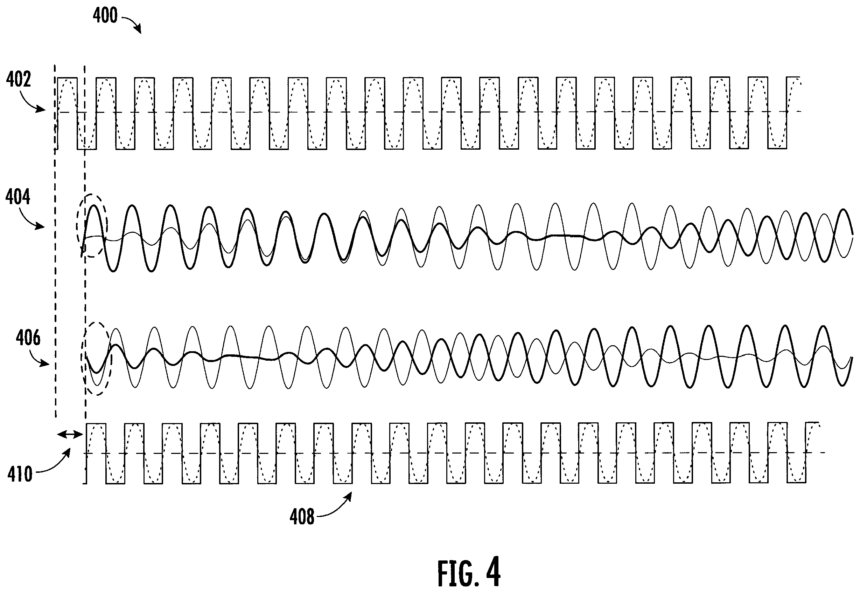

FIG. 4 illustrates a reconstruction 400 of a sign signal. The reconstruction 400 of the sign signal may be implemented by the resolver interface circuitry 302, for example, by the sine signal rectifier and integrator 304 and/or the cosine signal rectifier and integrator 306. The reconstruction 400 of the sign signal may be implemented by an internal logic such as an FSM.

The reconstruction 400 of the sign signal may comprise numerous steps. For example, the reconstruction 400 of the sign signal may comprise receiving, by a resolver and from a signal generator, an excitation signal 402. The excitation signal 402 may be an excitation sine signal and/or an excitation cosine signal. In the example of FIG. 4, the excitation signal 402 is illustrated as an excitation sine signal. The excitation signal 402 may be comprised of a sine wave and a square wave, wherein the sine wave (dashed line) is the signal used to excite the resolver 312 and the square wave (solid line) is the excitation sign signal.

The reconstruction 400 of the sign signal may comprise comparing resolver feedback signals. For example, a first resolver feedback sine and cosine signal 404 may be comprised of a sine signal and a cosine signal. The first resolver feedback sine and cosine signals 404 may correspond to an initial rotor angle of 0 degrees. In the example of 404, the absolute value of the cosine signal is greater than the absolute value of the sine signal, and the cosine signal is positive. Therefore, according to the method 100 described herein, the cosine position sensing variable may have a value of 1. A second resolver feedback sine and cosine signal 406 may be comprised of a sine signal and a cosine signal. The second resolver feedback sine and cosine signals 406 may correspond to an initial rotor angle of 240 degrees. In the example of 406, the absolute value of the sine signal is greater than the absolute value of the cosine signal, and the sine signal is negative. Therefore, according to the method 100 described herein, the sine position sensing variable may have a value of 0.

The reconstruction 400 of the sign signal may operate differently depending on the initial rotor angle. For example, if the initial rotor angle is 0 degrees, then the resolver outputs (e.g., the first resolver feedback sine and cosine signals 404) have the same sign as the excitation signal 402. If the initial rotor angle is 240 degrees, the resolver outputs (e.g., the second resolver feedback sine and cosine signals 406) have an inverted sign in comparison with the excitation signal 402.

The reconstruction 400 of the sign signal may comprise reconstruction, by an internal logic such as an FSM, of the sign of the received excitation signal while accounting for an external delay 410 resulting from the excitation signals from the resolver. The FSM may interpret various types of cases (e.g., various initial rotor angles) and appropriately reconstruct the sign signal. The reconstructed signal may either follow the sign of the resolver outputs, or it may be an inversion of the resolver outputs. The FSM therefore tracks the various angles of the rotor using the one or more position sensing variables.

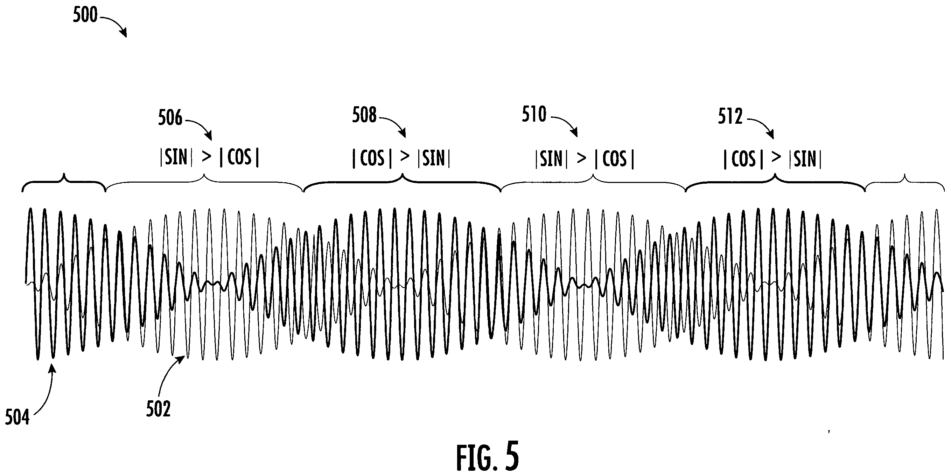

FIG. 5 illustrates a comparison 500 of reference signals. The reference signals may comprise a sine reference signal 502 and a cosine reference signal 504. The sine reference signal 502 may be the sine modulated output of a resolver. The cosine reference signal 504 may be the cosine modulated output of the resolver. The comparison 500 may be implemented to determine which of the reference signals is larger in absolute value. These reference signals are compared over time. Thus, there are periods when the sine reference signal 502 is greater than the cosine reference signal 504 and there are periods when the cosine reference signal 504 is greater than the sine reference signal 502. At period 506 and period 510, the absolute value of the sine reference signal 502 is greater than the absolute value of the cosine reference signal 504. At period 508 and period 512, the absolute value of the cosine reference signal 504 is greater than the absolute value of the sine reference signal 502. Dynamically determining which reference signal is larger and selecting the larger reference signal allows for greater accuracy in reconstruction of a sign signal. Using the larger reference signal may improve accuracy of the sign signal reconstruction.

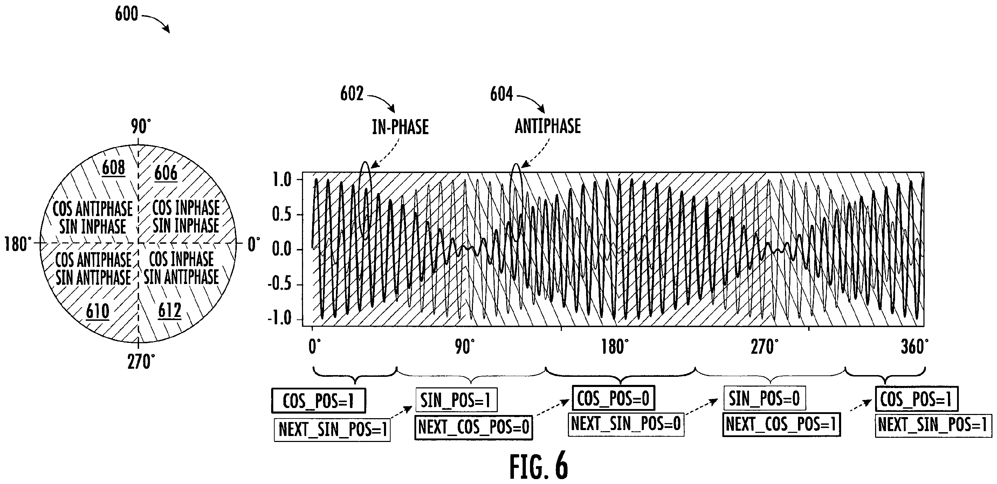

FIG. 6 illustrates a reconstruction 600 of an excitation sign signal based on resolver feedbacks as a function of rotor angle indicating the position of a rotor (or shaft, motor, etc.). The resolver feedbacks may comprise at least one sine signal, at least one cosine signal, and/or the like. In comparing the resolver feedbacks, it may be determined that the at least one sine signal and the at least one cosine signal are in phase 602 with one another at some times and antiphase 604 to one another at other times. Based on determining whether the resolver feedback signals are in phase or antiphase and based on starting values of one or more position sensing variables, an upcoming transition (e.g., from sine > cosine to cosine > sine) may be predicted. For example, the phase of the at least one sine signal and the at least one cosine signal are illustrated in the circle of FIG. 6. At 606, the at least one sine signal is in phase and the at least one cosine signal is in phase. At 608, the at least one sine signal is in phase and the at least one cosine signal is antiphase. At 610, the at least one sine signal is antiphase and the at least one cosine signal is antiphase. At 612, the at least one sine signal is antiphase and the at least one cosine signal is in phase. Based on which quadrant (e.g., of 606, 608, 610, or 612) best describes the phase of the resolver feedbacks at any given time, the reconstruction 600 may prepare for the next transition and the next reference zone at which the at least one sine signal will become larger than the at least one cosine signal (and/or vice versa). The reconstruction 600 may prepare, based on which quadrant best describes the phase of the resolver feedbacks, the next correct value of one or more position sensing variables for the sign reconstruction.

For example, an initial cosine position sensing variable (e.g., cos_pos) may have a value of 1 corresponding to a first region in which the absolute value of the at least one cosine signal is greater than the absolute value of the at least one sine signal. The next value of a sine position sensing variable (e.g., next_sin_pos = 1 = sin_pos) goes into effect once absolute value of the at least one sine signal is greater than the absolute value of the at least one cosine signal. This pattern may continue according to the illustration of FIG. 6 as the at least one sine signal and the at least one cosine signal continue to propagate.

The reconstruction 600 of an excitation sign signal may be implemented by an internal logic (e.g., an FSM). An FSM may reconstruct the rectification sign signal based on information received from resolver feedback signals. The FSM may understand dynamically in which quadrants the sine and/or cosine feedbacks are in phase and/or antiphase to one another. The information indicating the phase of the sine and/or cosine feedbacks may be combined with an expected sine position sensing variable and/or cosine position sensing variable zone transition by the FSM. If the sine and/or cosine reference signal is changed, for example, the FSM may predict in real-time how to reconstruct the excitation sign signal: if the sine position sensing variable and/or cosine position sensing variable is equal to 0, the sign of the sine and/or cosine reference signal may be reversed for the sign reconstruction; and if the sine position sensing variable and/or the cosine position sensing variable is equal to 1, the sign reconstruction may correspond to the sign of the sine and/or cosine reference signal.

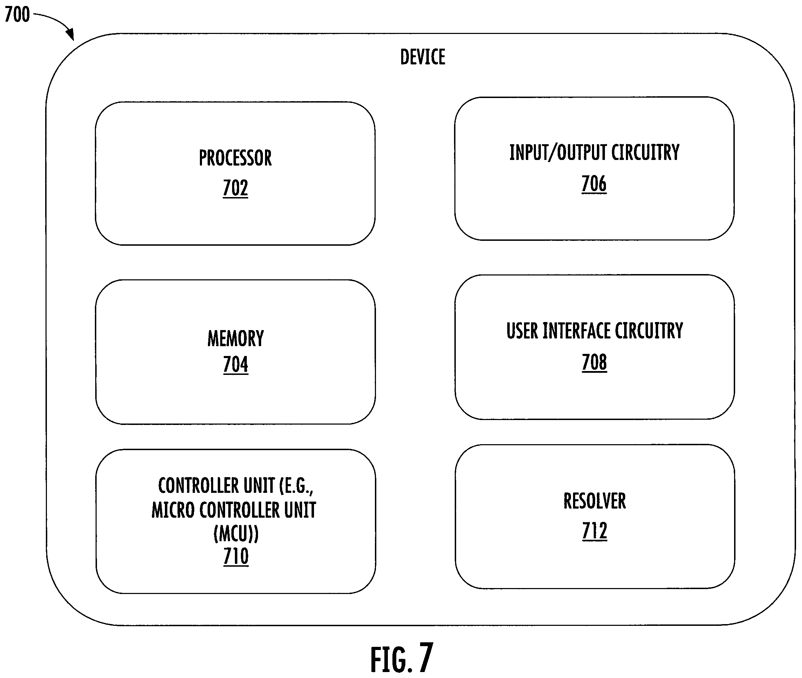

FIG. 7 illustrates an exemplary device 700 for implementing rectification of resolver feedbacks using a real-time synchronization technique. The device 700 may be a traction inverter system of an electric motor, for example, such as an electric motor in automotive applications. The device 700 may comprise at least one processor 702, at least one memory 704, at least one input/output circuitry 706, at least one user interface circuitry 708, at least one controller unit 710, at least one resolver 712, and/or other components.

The at least one processor 702 may implement the method 100 described herein. For example, the at least one processor 702 may be configured to rectify resolver feedback signals based on one or more position sensing variables being greater than a threshold. For example, the at least one processor 702 may be configured to reconstruct a rectification sign signal by dynamically selecting the larger signal (in absolute value) of sine and cosine resolver feedback signals. For example, the at least one processor 702 may be configured to reconstruct the rectification sign signal using a method that comprises at least to stages: a locking stage and/or a locked (e.g., working) stage.

The at least one memory 704 may be configured to store information in the device 700. For example, the at least one memory 704 may be configured to store a threshold for determining whether sine and/or cosine signals are not impacted by noise. For example, the at least one memory 704 may be configured to store information indicating which signal of sine and/or cosine signals is larger. For example, the at least one memory 704 may be configured to store information indicating the phase of the sine and/or cosine signals. For example, the at least one memory 704 may be configured to store one or more position sensing variables (e.g., at least one sine position sensing variable and/or at least one cosine position sensing variable).

The at least one input/output circuitry 706 may be configured to provide inputs and/or outputs to the device 700. For example, inputs may be configured to transmit information to the device 700. For example, outputs may be configured to transmit information from the device 700 to one or more other devices.

The at least one user interface 708 may be configured to provide a user interface for the device 700. One or more users may interact with the device 700 via the at least one user interface 708.

The at least one controller unit 710 may be a micro controller unit (MCU), for example, such as the MCU 300. The at least one controller unit 710 may be configured to generate one or more excitation signals, for example, to excite a resolver such as the resolver 712. The MCU 710 may further comprise at least one signal generator and/or at least one signal rectifier and integrator.

The at least one resolver 712 may be a resolver, for example, such as the resolver 312. The resolver 712 may be excited by the excitation signals. The at least one resolver 712 may modulate the excitation signals. Demodulation may be performed by rectifying and integrating the received resolver output signals. The resolver 712 may be configured to receive an initial rotor angle indicating an initial position of a rotor (or shaft, motor, etc.). Based on the initial rotor angle and/or the one or more modulated signals, the resolver 712 may generate demodulated signals (e.g., at least one demodulated sine sample signal and/or at least one demodulated cosine sample signal).

### CONCLUSION

It should be readily appreciated that the embodiments of the systems and apparatuses described herein may be configured in various additional and alternative manners in addition to those expressly described herein.

Operations and/or functions of the present disclosure have been described herein, such as in flowcharts. As will be appreciated, computer program instructions may be loaded onto a computer or other programmable apparatus (e.g., hardware) to produce a machine, such that the resulting computer or other programmable apparatus implements the operations and/or functions described in the flowchart blocks herein. These computer program instructions may also be stored in a computer-readable memory that may direct a computer, processor, or other programmable apparatus to operate and/or function in a particular manner, such that the instructions stored in the computer-readable memory produce an article of manufacture, the execution of which implements the operations and/or functions described in the flowchart blocks. The computer program instructions may also be loaded onto a computer, processor, or other programmable apparatus to cause a series of operations to be performed on the computer, processor, or other programmable apparatus to produce a computer-implemented process such that the instructions executed on the computer, processor, or other programmable apparatus provide operations for implementing the functions and/or operations specified in the flowchart blocks. The flowchart blocks support combinations of means for performing the specified operations and/or functions and combinations of operations and/or functions for performing the specified operations and/or functions. It will be understood that one or more blocks of the flowcharts, and combinations of blocks in the flowcharts, can be implemented by special purpose hardware-based computer systems which perform the specified operations and/or functions, or combinations of special purpose hardware with computer instructions. While this specification contains many specific embodiments and implementation details, these should not be construed as limitations on the scope of any disclosures or of what may be claimed, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

While operations and/or functions are illustrated in the drawings in a particular order, this should not be understood as requiring that such operations and/or functions be performed in the particular order shown or in sequential order, or that all illustrated operations be performed, to achieve desirable results. In certain circumstances, operations and/or functions in alternative ordering may be advantageous. In some cases, the actions recited in the claims may be performed in a different order and still achieve desirable results. Thus, while particular embodiments of the subject matter have been described, other embodiments are within the scope of the following claims.

While this detailed description has set forth some embodiments of the present invention, the appended claims cover other embodiments of the present invention which differ from the described embodiments according to various modifications and improvements.

## Claims

1. An apparatus comprising:
a micro controller unit, MCU (300), configured to generate a rectification signal (308);
a resolver (312) configured to receive one or more positions of a motor and configured to generate at least one sine signal (316) and at least one cosine signal (318) based on the rectification signal generated by the MCU (300) and based on an initial position (314) of the one or more positions of a motor; and
a signal rectifier (304, 306) in the MCU (300), wherein the signal rectifier is configured to reconstruct a sign signal based on a position sensing variable, wherein the position sensing variable is based on an absolute value of at least one sine sample signal exceeding a threshold or an absolute value of at least one cosine sample signal exceeding the threshold.

2. The apparatus of claim 1, wherein the MCU (300) is further configured to provide, via a signal generator, the rectification signal to the resolver (312).

3. The apparatus of claim 1, wherein the MCU (300) comprises a resolver interface circuitry (302), the resolver interface circuitry (302) further comprising an excitation generator circuitry (202) configured to generate an excitation signal (308) and a demodulation circuitry (204) configured to perform rectification sign signal reconstruction.

4. The apparatus of claim 3, wherein the resolver interface circuitry (302) is configured to generate the rectification signal, wherein the rectification signal is a rectification sign signal synchronized with one or more modulated feedbacks of the resolver (312).

5. The apparatus of claim 3, wherein the resolver interface circuitry (302) is configured to set a sign of the reconstructed sign signal based on a sign of the position sensing variable.

6. The apparatus of claim 1, wherein the threshold is associated with noise in the apparatus.

7. The apparatus of claim 1, wherein the position sensing variable is based on the initial position (314) of the one or more positions of the motor.

8. A system comprising:
a motor configured to have one or more positions; and
an apparatus according to any of the previous claims.

9. A method comprising:
receiving, by a resolver (312) and from a motor, one or more positions of a motor;
generating, by a micro controller unit, MCU (300), a rectification signal (308);
generating, by the resolver (312) and based on the rectification signal generated by the MCU (300) and based on an initial position (314) of the one or more positions of the motor, at least one sine signal (316) and at least one cosine signal (318); and
reconstructing, by a signal rectifier (304, 306) in the MCU (300), a sign signal based on a position sensing variable, wherein the position sensing variable is based on an absolute value of at least one sine sample signal exceeding a threshold or an absolute value of at least one cosine sample signal exceeding the threshold.

10. The method of claim 9, wherein the MCU (300) comprises a resolver interface circuitry (302), the resolver interface circuitry further comprising an excitation generator circuitry (202) configured to generate an excitation signal (308) and a demodulation circuitry (204) configured to perform rectification sign signal reconstruction.

11. The method of claim 10, further comprising:
generating, by the resolver interface circuitry (302), the rectification signal, wherein the rectification signal is a rectification sign signal synchronized with one or more modulated feedbacks of the resolver (312).

12. The method of claim 10, further comprising:
setting, by the resolver interface circuitry (302), a sign of the reconstructed sign signal based on a sign of the position sensing variable.

13. The method of claim 9, wherein the threshold is associated with noise impacting the at least one sine sample signal or the at least one cosine sample signal.

14. The method of claim 9, wherein the position sensing variable is based on the initial position (314) of the one or more positions of the motor.
